(19) Europäisches Patentamt
European Patent Office
Office européen des brevets

(11) **EP 3 217 618 B1**

(12) **EUROPEAN PATENT SPECIFICATION**

(45) Date of publication and mention
of the grant of the patent:
**20.02.2019 Bulletin 2019/08**

(21) Application number: **14908823.9**

(22) Date of filing: **26.12.2014**

(51) Int Cl.:
***H04L 25/03*** *(2006.01)*

(86) International application number:
**PCT/CN2014/095111**

(87) International publication number:
**WO 2016/101255 (30.06.2016 Gazette 2016/26)**

(54) **SIGNAL COMPENSATION METHOD AND DEVICE**

SIGNALKOMPENSIERUNGSVERFAHREN UND -VORRICHTUNG

PROCÉDÉ ET DISPOSITIF DE COMPENSATION DE SIGNAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.09.2017 Bulletin 2017/37**

(73) Proprietor: **Huawei Technologies Co. Ltd.
Shenzhen, Guangdong 518129 (CN)**

(72) Inventors:
• **CHEN, Wei
Shenzhen
Guangdong 518129 (CN)**
• **MAN, Jiangwei
Shenzhen
Guangdong 518129 (CN)**

• **ZENG, Li
Shenzhen
Guangdong 518129 (CN)**

(74) Representative: **Pfenning, Meinig & Partner mbB
Patent- und Rechtsanwälte
Theresienhöhe 11a
80339 München (DE)**

(56) References cited:
**CN-A- 1 394 421      CN-A- 101 965 719
JP-A- 2014 023 160    US-A- 5 031 195
US-A1- 2006 245 765   US-A1- 2014 056 345
US-A1- 2014 133 544   US-B1- 8 897 387**

**Description**

**TECHNICAL FIELD**

The present invention relates to the field of optical communications technologies, and in particular, to a signal compensation method and device.

**BACKGROUND**

In a development process of communications technologies, much work has been done to increase an information transmission rate and distance and improve availability, reliability, and cost-effectiveness of a communications system, and remarkable achievements have been made. As a latest achievement in the development of modern communications technologies, an optical communications technology has become a cornerstone of modern communications, and is a main transfer tool of various types of information in a future information society.

An optical fiber is used as a communication channel to constitute an optical fiber communications system. In addition to characteristics of a wide transmission frequency band, a large communication capacity, a small transmission loss, a long trunk distance, and a strong anti-electromagnetic interference capability of the optical fiber communications system, loss and dispersion are most important transmission characteristics of the optical fiber and are also basic problems of the optical fiber communications system.

Due to existence of dispersion, a broadening phenomenon occurs on an optical pulse during transmission on an optical fiber channel. The pulse broadening causes intersymbol interference (Intersymbol Interference, ISI for short) between adjacent pulses. This shortens a transmission distance and increases a bit error rate of the system, thereby decreasing performance of the optical fiber communications system.

To reduce or eliminate impact of the ISI on channel performance, a signal bandwidth compensation mechanism is proposed. The compensation mechanism specifically includes feed-forward equalization (Feed-Forward Equalization, FFE for short), decision-feedback equalization (Decision-Feedback Equalization, DFE for short), and maximum-likelihood sequence equalization (Maximum-Likelihood Sequence Equalization, MLSE for short). The FFE is used to pre-compensate for a system loss, the DEF is used to generate controllable ISI, and the MLSE is used to compensate for the generated controllable ISI, thereby improving the performance of the optical fiber communications system.

However, the foregoing compensation mechanism has the following disadvantage: Filtering coefficient balance is performed only on the FFE and the DFE during system compensation, and as a result, improving the performance of the optical fiber communications system by using the compensation mechanism cannot satisfy people's requirements for the performance of the optical fiber communications system.

US5031195A discloses fully adaptive modem receiver for data-transmission systems which use trellis-coded modulation (TCM) and comprises an adaptive whitened-matched filter (WMF) and a reduced-state trellis decoder. The WMF consists of an adaptive linear equalizer with fractional-T spaced coefficients, and an adaptive linear predictor. The decoder combines the functions of equalization and TCM decoding. It employs combined intersymbol interference (ISI) and code states which exploit the set-partitioning structure of the underlying TCM code to provide full or reduced-state information about past ISI terms. The decoder branch metric cancels those ISI terms that are not, or are only partially, represented by the trellis states.

US2006245765A1 discloses systems for an optical communication channel. A data signal is preconditioned prior to transmission over a fiber optic cable to minimize signal distortion and transmitted over a fiber optic cable. Preconditioning may include none, one or more, or all of the following: encoding the data signal using a run length limited code, correlating bits of the data signal, and spreading out the pulses in the time-domain in the data signal. The pulse spreading function can be implemented either in the electrical domain prior to the electrical-to-optical conversion; in the optical domain during and/or after the electrical-to-optical conversion; or a combination of both. During reception, the data signal and clock are recovered.; Recovery may include maintaining an amplitude in an electrical signal, filtering the electrical signal, shaping the electrical signal, and removing distortions and intersymbol interference (ISI) from the received electrical signal

**SUMMARY**

In view of this, embodiments of the present invention provide a signal compensation method and device according to the independent claims, to resolve a problem that an existing compensation mechanism does not greatly improve performance of an optical fiber communications system. Further advantages can be achieved by the features disclosed in the dependent claims.

According to a first aspect, a signal compensation device is provided, including a first compensation module, a balance filtering module, and a second compensation module, where:

the first compensation module is configured to receive an input signal sequence suffering from intersymbol interference ISI interference, use a first filtering coefficient to perform filtering compensation on the received signal sequence, to obtain a first compensation signal sequence, and send the first compensation signal sequence to the balance filtering module;

the balance filtering module is configured to use a balance filtering coefficient to perform filtering compensation on the first compensation signal sequence that is sent by the first compensation module, to obtain a balance compensation result, and send the balance compensation result to the second compensation module, where the balance filtering coefficient is obtained by adjusting, according to a first compensation error sent by the second compensation module, a balance filtering coefficient used last time; and

the second compensation module is configured to receive the balance compensation result sent by the balance filtering module, perform sequence estimation on the received balance compensation result and output the balance compensation result, obtain the first compensation error by means of calculation according to a compensation error value obtained last time by means of calculation and a compensation error value obtained the last but one time by means of calculation, and send the first compensation error to the balance filtering module.

With reference to the first aspect, in a first possible implementation, the second compensation module is specifically configured to perform subtraction on the compensation error value obtained last time by means of calculation and the compensation error value obtained the last but one time by means of calculation, where a difference obtained is the first compensation error.

With reference to the first aspect, or with reference to the first possible implementation of the first aspect, in a second possible implementation, the second compensation module is further configured to: when receiving the balance compensation result sent by the balance filtering module, calculate a compensation error value of the currently received balance compensation result; and obtain a second compensation error by means of calculation according to the compensation error value obtained last time by means of calculation and the compensation error value of the currently received balance compensation result, and send the second compensation error obtained by means of calculation to the balance filtering module.

With reference to the first aspect, or with reference to the first possible implementation of the first aspect, or with reference to the second possible implementation of the first aspect, in a third possible implementation, the balance filtering module is specifically configured to obtain the $j$th balance filtering coefficient in the following manner:

$$b_{j(\text{current})} = b_{j(\text{last time})} + \mu * \text{sign}\left(e_{\text{last but one time}} - e_{\text{last time}}\right),$$

where

$b_{j(\text{current})}$ is an obtained coefficient weight of the $j$th balance filtering coefficient that is currently used, a value range of $j$ is 0 to $L_b$, $L_b$ is a length of the balance filtering coefficient, $b_{j(\text{last time})}$ is a basic coefficient weight of the $j$th balance filtering coefficient used last time, $\mu$ is a coefficient change length of the balance filtering coefficient,

$e_{\text{last but one time}}$ - $e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

With reference to the first aspect, or with reference to the first possible implementation of the first aspect, or with reference to the second possible implementation of the first aspect, or with reference to the third possible implementation of the first aspect, in a fourth possible implementation, the first compensation module is further configured to send, at an initialization stage, the first filtering coefficient to the balance filtering module; and

the balance filtering module is further configured to receive the first filtering coefficient sent by the first compensation module, determine, according to a coefficient weight of the first filtering coefficient, a basic coefficient weight of an initialized balance filtering coefficient used by the balance filtering module, and obtain an initial value of the balance filtering coefficient according to the basic coefficient weight of the initialized balance filtering coefficient used by the balance filtering module.

With reference to the fourth possible implementation of the first aspect, in a fifth possible implementation, the balance filtering module is specifically configured to: if the received first filtering coefficient sent by the first compensation module is $F(z) = \sum_{i=0}^{L_f} f_i z^{-i}$ , determine, according to the coefficient weight of the first filtering coefficient and in the following manner, the basic coefficient weight of the initialized balance filtering coefficient used by the balance filtering module:

$$b_0 = f_0; b_j = -f_i,$$

where

$b_j$ is a basic coefficient weight of the $j$th balance filtering coefficient that is initialized, the value range of $j$ is 0 to $L_b$, $L_b$ is the length of the balance filtering coefficient, $f_i$ is a coefficient weight of the $j$th first filtering coefficient, a value range of $i$ is 0 to $L_f$, and $L_f$ is a length of the first filtering coefficient.

With reference to the first aspect, or with reference to the first possible implementation of the first aspect, or with reference to the second possible implementation of the first aspect, or with reference to the third possible implementation of the first aspect, or with reference to the fourth possible implementation of the first aspect, or with reference to the fifth possible implementation of the first aspect, in a sixth possible implementation, the first compensation module is further configured to calculate an error result according to a first compensation signal sequence obtained last time and a decision value of the first compensation signal sequence obtained last time, adjust the first filtering coefficient according to the error result obtained by means of calculation, and use an adjusted first filtering coefficient to perform filtering compensation on the currently received signal sequence.

According to a second aspect, a signal compensation method is provided, including:

receiving an input signal sequence suffering from intersymbol interference ISI interference, and using a first filtering coefficient to perform filtering compensation on the received signal sequence, to obtain a first compensation signal sequence;

using a balance filtering coefficient to perform filtering compensation on the first compensation signal sequence, to obtain a balance compensation result, where the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and

performing sequence estimation on the obtained balance compensation result and outputting the balance compensation result.

With reference to the second aspect, in a first possible implementation, that the first compensation error is obtained by means of calculation according to a compensation error value obtained last time by means of calculation and a compensation error value obtained the last but one time by means of calculation includes:

performing subtraction on the compensation error value obtained last time by means of calculation and the compensation error value obtained the last but one time by means of calculation, where a difference obtained is the first compensation error.

With reference to the second aspect, or with reference to the first possible implementations of the second aspect, in a second possible implementation, the method further includes:

when obtaining the balance compensation result, calculating a compensation error value of the currently received balance compensation result; and

obtaining a second compensation error by means of calculation according to the compensation error value obtained last time by means of calculation and the compensation error value of the currently received balance compensation result, where the second compensation error is used to adjust a currently used balance filtering coefficient.

With reference to the second aspect, or with reference to the first possible implementation of the second aspect, or with reference to the second possible implementation of the second aspect, in a third possible implementation, the $j$th balance filtering coefficient that is currently used is obtained in the following manner:

$$b_{j(\text{current})} = b_{j(\text{last time})} + \mu * \text{sign}(\text{e}_{\text{last but one time}} - \text{e}_{\text{last time}}),$$

where

$b_{j(\text{current})}$ is an obtained coefficient weight of the $j$th balance filtering coefficient that is currently used, a value range of $j$ is 0 to $L_b$, $L_b$ is a length of the balance filtering coefficient, $b_{j(\text{last time})}$ is a basic coefficient weight of the $j$th balance filtering coefficient used last time, $\mu$ is a coefficient change length of the balance filtering coefficient, $\text{e}_{\text{last but one time}} - \text{e}_{\text{last time}}$ is

the first compensation error, $e_{last\ but\ one\ time}$ is the compensation error value obtained the last but one time by means of calculation, and $e_{last\ time}$ is the compensation error value obtained last time by means of calculation.

With reference to the second aspect, or with reference to the first possible implementation of the second aspect, or with reference to the second possible implementation of the second aspect, or with reference to the third possible implementation of the second aspect, in a fourth possible implementation, the method further includes:

determining, at an initialization stage, a basic coefficient weight of an initialized balance filtering coefficient according to a coefficient weight of the first filtering coefficient; and
obtaining an initial value of the balance filtering coefficient according to the basic coefficient weight of the initialized balance filtering coefficient.

With reference to the fourth possible implementation of the second aspect, in a fifth possible implementation, the determining a basic coefficient weight of an initialized balance filtering coefficient according to a coefficient weight of the first filtering coefficient includes:

if the first filtering coefficient is $F(z) = \sum_{i=0}^{L_f} f_i z^{-i}$ , determining the basic coefficient weight of the initialized balance filtering coefficient in the following manner:

$$b_0 = f_0; b_j = -f_i,$$

where

$b_j$ is a basic coefficient weight of the $j$th balance filtering coefficient that is initialized, the value range of $j$ is 0 to $L_b$, $L_b$ is the length of the balance filtering coefficient, $f_j$ is a coefficient weight of the $j$th first filtering coefficient, a value range of $i$ is 0 to $L_f$, and $L_f$ is a length of the first filtering coefficient.

With reference to the second aspect, or with reference to the first possible implementation of the second aspect, or with reference to the second possible implementation of the second aspect, or with reference to the third possible implementation of the second aspect, or with reference to the fourth possible implementation of the second aspect, or with reference to the fifth possible implementation of the second aspect, in a sixth possible implementation, the method further includes:

calculating an error result according to a first compensation signal sequence obtained last time and a decision value of the first compensation signal sequence obtained last time; and
adjusting the first filtering coefficient according to the error result obtained by means of calculation; and
the using a first filtering coefficient to perform filtering compensation on the received signal sequence, to obtain a first compensation signal sequence includes:
using an adjusted first filtering coefficient to perform filtering compensation on the currently received signal sequence, to obtain the first compensation signal sequence.

According to a third aspect, a signal compensation device is provided, including:

a signal receiver, configured to receive an input signal sequence suffering from intersymbol interference ISI interference;
a processor, configured to use a first filtering coefficient to perform filtering compensation on the received signal sequence, to obtain a first compensation signal sequence, and use a balance filtering coefficient to perform filtering compensation on the first compensation signal sequence, to obtain a balance compensation result, where the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and
a signal transmitter, configured to perform sequence estimation on the received balance compensation result and output the balance compensation result.

With reference to the third aspect, in a first possible implementation, that the first compensation error is obtained by means of calculation according to a compensation error value obtained last time by means of calculation and a compensation error value obtained the last but one time by means of calculation includes:

performing subtraction on the compensation error value obtained last time by means of calculation and the compensation error value obtained the last but one time by means of calculation, where a difference obtained is the first compensation error.

With reference to the third aspect, or with reference to the first possible implementation of the third aspect, in a second possible implementation, the processor is further configured to: when obtaining the balance compensation result, calculate a compensation error value of the currently received balance compensation result; and

obtain a second compensation error by means of calculation according to the compensation error value obtained last time by means of calculation and the compensation error value of the currently received balance compensation result, where the second compensation error is used to adjust a currently used balance filtering coefficient.

With reference to the third aspect, or with reference to the first possible implementation of the third aspect, or with reference to the second possible implementation of the third aspect, in a third possible implementation, the processor obtains, in the following manner, the $j^{\text{th}}$ balance filtering coefficient that is currently used:

$$b_{j(\text{current})} = b_{j(\text{last time})} + \mu * \text{sign}(e_{\text{last but one time}} - e_{\text{last time}}),$$

where

$b_{j(\text{current})}$ is an obtained coefficient weight of the $j^{\text{th}}$ balance filtering coefficient that is currently used, a value range of $j$ is 0 to $L_b$, $L_b$ is a length of the balance filtering coefficient, $b_{j(\text{last time})}$ is a basic coefficient weight of the $j^{\text{th}}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

With reference to the third aspect, or with reference to the first possible implementation of the third aspect, or with reference to the second possible implementation of the third aspect, or with reference to the third possible implementation of the third aspect, in a fourth possible implementation, the processor is further configured to: determine, at an initialization stage, a basic coefficient weight of an initialized balance filtering coefficient according to a coefficient weight of the first filtering coefficient; and obtain an initial value of the balance filtering coefficient according to the basic coefficient weight of the initialized balance filtering coefficient.

With reference to the fourth possible implementation of the third aspect, in a fifth possible implementation, that the processor determines a basic coefficient weight of an initialized balance filtering coefficient according to a coefficient weight of the first filtering coefficient includes:

if the first filtering coefficient is $F(z) = \sum_{i=0}^{L_f} f_i z^{-i}$ , determining the basic coefficient weight of the initialized balance filtering coefficient in the following manner:

$$b_0 = f_0; b_j = -f_i,$$

where

$b_j$ is a basic coefficient weight of the $j^{\text{th}}$ balance filtering coefficient that is initialized, the value range of $j$ is 0 to $L_b$, $L_b$ is the length of the balance filtering coefficient, $f_i$ is a coefficient weight of the $j^{\text{th}}$ first filtering coefficient, a value range of $i$ is 0 to $L_f$, and $L_f$ is a length of the first filtering coefficient.

With reference to the third aspect, or with reference to the first possible implementation of the third aspect, or with reference to the second possible implementation of the third aspect, or with reference to the third possible implementation of the third aspect, or with reference to the fourth possible implementation of the third aspect, or with reference to the fifth possible implementation of the third aspect, in a sixth possible implementation, the processor is further configured to calculate an error result according to a first compensation signal sequence obtained last time and a decision value of the first compensation signal sequence obtained last time, and adjust the first filtering coefficient according to the error result obtained by means of calculation; and

use an adjusted first filtering coefficient to perform filtering compensation on the currently received signal sequence, to obtain the first compensation signal sequence.

The embodiments of the present invention have the following beneficial effects:

According to the embodiments of the present invention, an input signal sequence suffering from ISI interference is received, and a first filtering coefficient is used to perform filtering compensation on the received signal sequence to obtain a first compensation signal sequence;

a balance filtering coefficient is used to perform filtering compensation on the first compensation signal sequence to obtain a balance compensation result, where the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and sequence estimation is performed on the received balance compensation result and the balance compensation result is output. A first compensation error is generated by a back-end compensation module, the first compensation error is used to adjust a balance filtering coefficient in an iterative manner, and an adjusted balance filtering coefficient is used to perform filtering compensation on a first compensation signal sequence, thereby balancing performance between compensation modules at various levels, effectively compensating for a signal sequence suffering from ISI interference, and improving performance of an optical fiber communications system.

## BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and persons of ordinary skill in the art may still derive other drawings from these accompanying drawings without creative efforts.

FIG. 1 is a schematic structural diagram of a signal compensation device according to the present invention;
FIG. 2 is a schematic flowchart of a signal compensation method according to the present invention; and
FIG. 3 is a schematic structural diagram of a signal compensation device according to the present invention.

## DESCRIPTION OF EMBODIMENTS

To implement the objectives of the present invention, the embodiments of the present invention provide a signal compensation method and device. An input signal sequence suffering from ISI interference is received, and a first filtering coefficient is used to perform filtering compensation on the received signal sequence to obtain a first compensation signal sequence; a balance filtering coefficient is used to perform filtering compensation on the first compensation signal sequence to obtain a balance compensation result, where the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and sequence estimation is performed on the received balance compensation result and the balance compensation result is output. A first compensation error is generated by a back-end compensation module, the first compensation error is used to adjust a balance filtering coefficient in an iterative manner, and an adjusted balance filtering coefficient is used to perform filtering compensation on a first compensation signal sequence, thereby balancing performance between compensation modules at various levels, effectively compensating for a signal sequence suffering from ISI interference, and improving performance of an optical fiber communications system.

The following further describes the embodiments of the present invention in detail with reference to this specification. Apparently, the described embodiments are merely some but not all of the embodiments of the present invention. All other embodiments obtained by persons of ordinary skill in the art based on the embodiments of the present invention without creative efforts shall fall within the protection scope of the present invention.

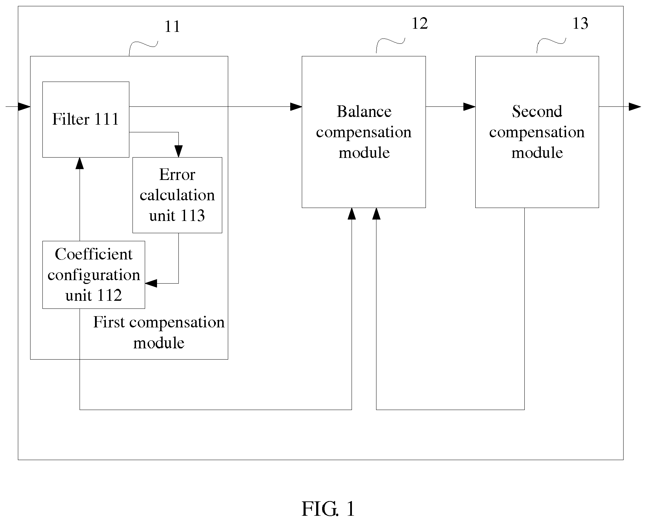

FIG. 1 is a schematic structural diagram of a signal compensation device according to an embodiment of the present invention. The signal compensation device includes a first compensation module 11, a balance filtering module 12, and a second compensation module 13.

The first compensation module 11 is configured to receive an input signal sequence suffering from ISI interference, use a first filtering coefficient to perform filtering compensation on the received signal sequence, to obtain a first compensation signal sequence, and send the first compensation signal sequence to the balance filtering module 12.

The balance filtering module 12 is configured to use a balance filtering coefficient to perform filtering compensation on the first compensation signal sequence that is sent by the first compensation module 11, to obtain a balance compensation result, and send the balance compensation result to the second compensation module 13. The balance filtering coefficient is obtained by adjusting, according to a first compensation error sent by the second compensation module 13, a balance filtering coefficient used last time.

The second compensation module 13 is configured to receive the balance compensation result sent by the balance filtering module 12, perform sequence estimation on the received balance compensation result and output the balance compensation result, obtain the first compensation error by means of calculation according to a compensation error value obtained last time by means of calculation and a compensation error value obtained the last but one time by means of calculation, and send the first compensation error to the balance filtering module 12.

Optionally, the first compensation module 11 is further configured to calculate an error result according to a first compensation signal sequence obtained last time and a decision value of the first compensation signal sequence obtained last time, adjust the first filtering coefficient according to the error result obtained by means of calculation, and use an adjusted first filtering coefficient to perform filtering compensation on the currently received signal sequence.

It should be noted that the decision value of the first compensation signal sequence obtained last time refers to a value obtained after the first compensation signal sequence obtained last time is quantized.

Specifically, the first compensation module 11 may include a filter 111 and a coefficient configuration unit 112. Optionally, the first compensation module 11 may further include an error calculation unit 113.

The filter 111 is configured to receive the input signal sequence suffering from the ISI interference, use the first filtering coefficient configured by the coefficient configuration unit 112, to perform filtering compensation on the received signal sequence, to obtain the first compensation signal sequence, and send the first compensation signal sequence to the balance filtering module 12.

For example, the received input signal sequence suffering from the ISI interference may be

$$r_k = \sum_{a=0}^{L_c} c_a * x_{k-a} + n_k \,,$$ where $r_k$ is the $k$th signal, $n_k$ is noise of the $k$th signal, $c_a$ is a coefficient to be compensated, a value range of $a$ is 0 to $L_c$, $L_c$ is a channel memory length, and $x$ is a signal sequence.

The coefficient configuration unit 112 is adapted to configure the first filtering coefficient. An FFE structure or a DFE structure may be used. The first filtering coefficient is adaptively configured by using a least mean square (Least mean square, LMS for short) algorithm or another algorithm.

For example, the first filtering coefficient is $F(z) = \sum_{i=0}^{L_f} f_i z^{-i}$ , where $f_i$ is the $i$th coefficient weight of the first filtering coefficient, a value range of $i$ is 0 to $L_f$, and $L_f$ is a length of the first filtering coefficient.

It should be noted that, to achieve a good compensation effect, $L_f$ is generally required to be greater than or equal to $L_c$.

The coefficient configuration unit 112 herein may be adapted to configure an initial first filtering coefficient. The first filtering coefficient obtained afterwards is obtained by means of adjustment according to the error result sent by the error calculation unit 113.

The error calculation unit 113 is configured to calculate the error result according to the first compensation signal sequence obtained last time and the decision value of the first compensation signal sequence obtained last time, and send the error result to the coefficient configuration unit 112.

The coefficient configuration unit 112 is specifically configured to adjust the first filtering coefficient according to the error result sent by the error calculation unit 113, and send the adjusted first filtering coefficient to the filter 111.

It should be noted that the signal compensation device recorded in this embodiment of the present invention is a cyclic execution device. After the second compensation module 13 sends a second compensation error obtained by means of calculation to the balance filtering module 12, the balance filtering module 12 may use the second compensation error to adjust the balance filtering coefficient, so as to perform filtering compensation when receiving the first compensation signal sequence sent by the first compensation module 11.

Therefore, the second compensation module adjusts, according to a difference between compensation error values obtained two consecutive times by means of calculation, the balance filtering coefficient used by the balance filtering module, to achieve a purpose of balancing performance of various compensation modules.

Specifically, the second compensation module 13 is specifically configured to perform subtraction on the compensation error value obtained last time by means of calculation and the compensation error value obtained the last but one time by means of calculation. A difference obtained is the first compensation error.

Optionally, the second compensation module 13 is further configured to: when receiving the balance compensation result sent by the balance filtering module, calculate a compensation error value of the currently received balance compensation result; and obtain the second compensation error by means of calculation according to the compensation error value obtained last time by means of calculation and the compensation error value of the currently received balance compensation result, and send the second compensation error obtained by means of calculation to the balance filtering module 12.

Specifically, the balance filtering module 12 is specifically configured to obtain the $j$th balance filtering coefficient in the following manner:

$$b_{j(\text{current})} = b_{j(\text{last time})} + \mu * \text{sign}\left(e_{\text{last but one time}} - e_{\text{last time}}\right),$$

where

$b_{j(\text{current})}$ is an obtained coefficient weight of the $j^{\text{th}}$ balance filtering coefficient that is currently used, a value range of $j$ is 0 to $L_b$, $L_b$ is a length of the balance filtering coefficient, $b_{j(\text{last time})}$ is a basic coefficient weight of the $j^{\text{th}}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

It should be noted that the first compensation module 11 is further configured to send, at an initialization stage, the first filtering coefficient to the balance filtering module 12.

The balance filtering module 12 is further configured to receive the first filtering coefficient sent by the first compensation module, determine, according to a coefficient weight of the first filtering coefficient, a basic coefficient weight of an initialized balance filtering coefficient used by the balance filtering module, and obtain an initial value of the balance filtering coefficient according to the basic coefficient weight of the initialized balance filtering coefficient used by the balance filtering module.

The balance filtering module 12 is specifically configured to: if the received first filtering coefficient sent by the first compensation module is $F(z) = \sum_{i=0}^{L_f} f_i z^{-i}$ , determine, according to the coefficient weight of the first filtering coefficient and in the following manner, the basic coefficient weight of the initialized balance filtering coefficient used by the balance filtering module:

$$b_0 = f_0; b_j = -f_i,$$

where

$b_j$ is a basic coefficient weight of the $j^{\text{th}}$ balance filtering coefficient that is initialized, the value range of $j$ is 0 to $L_b$, $L_b$ is the length of the balance filtering coefficient, $f_i$ is a coefficient weight of the $j^{\text{th}}$ first filtering coefficient, the value range of $i$ is 0 to $L_f$, and $L_f$ is the length of the first filtering coefficient.

The balance filtering module 12 is specifically configured to obtain the balance filtering coefficient according to a coefficient weight of a balance filtering coefficient obtained by means of adjustment, for example, the obtained balance filtering coefficient is

$$B(z) = \sum_{j=0}^{L_b} b_j * z^{-j},$$

where

$b_j$ is a coefficient weight of the $j^{\text{th}}$ balance filtering coefficient obtained by means of adjustment, the value range of $j$ is 0 to $L_b$, and $L_b$ is the length of the balance filtering coefficient.

The signal compensation device described in this embodiment of the present invention may be implemented by means of hardware, or may be implemented by means of software. No limitation is imposed herein. A first compensation error is generated by a back-end compensation module, the first compensation error is used to adjust a balance filtering coefficient in an iterative manner, and an adjusted balance filtering coefficient is used to perform filtering compensation on a first compensation signal sequence, thereby balancing performance between compensation modules at various levels, effectively compensating for a signal sequence suffering from ISI interference, and improving performance of an optical fiber communications system.

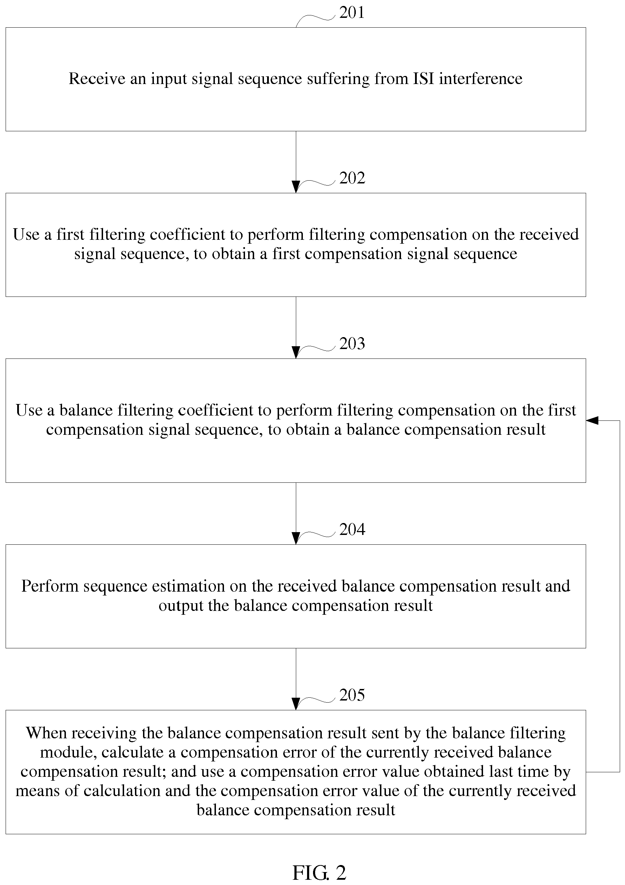

FIG. 2 is a schematic flowchart of a signal compensation method according to an embodiment of the present invention. The method may be described as follows.

Step 201: Receive an input signal sequence suffering from ISI interference.

In step 201, on an optical fiber communication link, ISI may easily occur on a communication signal. For example, due to a bandwidth limitation of a photoelectric transmitter or an electro-optic receiver, and the like, ISI occurs on a communication signal.

It is assumed that the received signal sequence suffering from the ISI interference is $r_k = \sum_{a=0}^{L_c} c_a * x_{k-a} + n_k$ ,

where $r_k$ is the $k^{th}$ signal, $n_k$ is noise of the $k^{th}$ signal, $c_a$ is a coefficient to be compensated, a value range of $a$ is 0 to $L_c$, $L_c$ is a channel memory length, and $x$ is a signal sequence.

Step 202: Use a first filtering coefficient to perform filtering compensation on the received signal sequence, to obtain a first compensation signal sequence.

In step 202, the first filtering coefficient may be an initially configured filtering coefficient, or may be obtained by adjusting, according to a feedback, a filtering coefficient used last time. If the first filtering coefficient is obtained by means of configuration, an FFE structure or a DFE structure may be used. The first filtering coefficient is adaptively configured by using a least mean square (Least mean square, LMS for short) algorithm or another algorithm.

For example, the first filtering coefficient is $F(z) = \sum_{i=0}^{L_f} f_i z^{-i}$, where $f_i$ is the $i^{th}$ coefficient weight of the first filtering coefficient, a value range of $i$ is 0 to $L_f$, and $L_f$ is a length of the first filtering coefficient.

It should be noted that, to achieve a good compensation effect, $L_f$ is generally required to be greater than or equal to $L_c$.

If the first filtering coefficient is obtained by adjusting, according to an error result that is fed back, the filtering coefficient used last time, the method specifically includes:

calculating the error result according to a first compensation signal sequence obtained last time and a decision value of the first compensation signal sequence obtained last time; and
obtaining an adjusted first filtering coefficient by adjusting the first filtering coefficient (that is, the filtering coefficient used last time) according to the error result obtained by means of calculation.

Step 203: Use a balance filtering coefficient to perform filtering compensation on the first compensation signal sequence, to obtain a balance compensation result.

The balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation.

In step 203, the $j^{th}$ balance filtering coefficient that is currently used is obtained in the following manner:

$$b_{j(\text{current})} = b_{j(\text{last time})} + \mu * \text{sign}(e_{\text{last but one time}} - e_{\text{last time}}),$$

where

$b_{j(\text{current})}$ is an obtained coefficient weight of the $j^{th}$ balance filtering coefficient that is currently used, a value range of $j$ is 0 to $L_b$, $L_b$ is a length of the balance filtering coefficient, $b_{j(\text{last time})}$ is a basic coefficient weight of the $j^{th}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

That is, the balance filtering coefficient is obtained in an iterative manner.

Therefore, an initial value of the balance filtering coefficient is determined in the following manner:

determining, at an initialization stage, a basic coefficient weight of an initialized balance filtering coefficient according to a coefficient weight of the first filtering coefficient; and
obtaining the initial value of the balance filtering coefficient according to the basic coefficient weight of the initialized balance filtering coefficient.

Specifically, if the first filtering coefficient is $F(z) = \sum_{i=0}^{L_f} f_i z^{-i}$, the basic coefficient weight of the initialized balance filtering coefficient is determined in the following manner:

$$b_0 = f_0; b_j = -f_i,$$

where

$b_j$ is a basic coefficient weight of the $j^{th}$ balance filtering coefficient that is initialized, the value range of $j$ is 0 to $L_b$, $L_b$ is the length of the balance filtering coefficient, $f_i$ is a coefficient weight of the $j^{th}$ first filtering coefficient, the value range of $i$ is 0 to $L_f$, and $L_f$ is the length of the first filtering coefficient.

Step 204: Perform sequence estimation on the received balance compensation result and output the balance compensation result.

Step 205: When receiving the balance compensation result sent by the balance filtering module, calculate a compensation error of the currently received balance compensation result; and perform step 203 according to a compensation error value obtained last time by means of calculation and the compensation error value of the currently received balance compensation result.

A second compensation error is used to adjust a currently used balance filtering coefficient.

In step 205, subtraction is performed on the compensation error value obtained last time by means of calculation and the compensation error value of the currently received balance compensation result, and a difference obtained is the second compensation error.

It should be noted that the operation performed in step 205 is a feedback operation. A balance filtering coefficient used by the balance filtering module is adjusted according to an error between two adjacent balance compensation results, to achieve a purpose of balancing performance of various compensation modules.

According to the description in this embodiment of the present invention, an input signal sequence suffering from ISI interference is received, and a first filtering coefficient is used to perform filtering compensation on the received signal sequence to obtain a first compensation signal sequence; a balance filtering coefficient is used to perform filtering compensation on the first compensation signal sequence to obtain a balance compensation result, where the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and sequence estimation is performed on the received balance compensation result and the balance compensation result is output. A first compensation error is generated by a back-end compensation module, the first compensation error is used to adjust a balance filtering coefficient in an iterative manner, and an adjusted balance filtering coefficient is used to perform filtering compensation on a first compensation signal sequence, thereby balancing performance between compensation modules at various levels, effectively compensating for a signal sequence suffering from ISI interference, and improving performance of an optical fiber communications system.

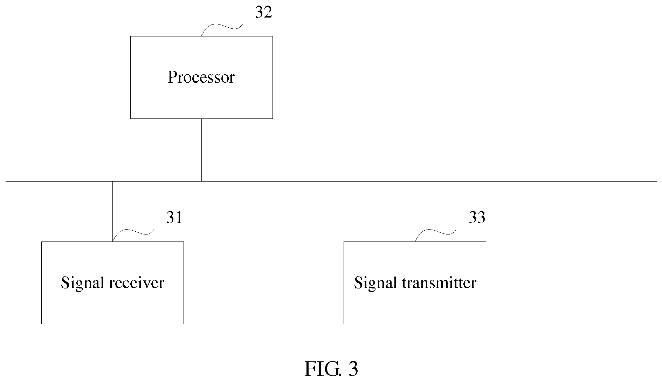

FIG. 3 is a schematic structural diagram of a signal compensation device according to an embodiment of the present invention. The signal compensation device has the foregoing signal compensation function, and may use a general computer structure. The signal compensation device entity may include a signal receiver 31, a processor 32, and a signal transmitter 33.

The signal receiver 31 is configured to receive an input signal sequence suffering from intersymbol interference ISI interference.

The processor 32 is configured to use a first filtering coefficient to perform filtering compensation on the received signal sequence, to obtain a first compensation signal sequence, and use a balance filtering coefficient to perform filtering compensation on the first compensation signal sequence, to obtain a balance compensation result. The balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation.

The signal transmitter 33 is configured to perform sequence estimation on the received balance compensation result and output the balance compensation result.

Specifically, that the processor 32 is obtained by means of calculation according to a compensation error value obtained last time by means of calculation and a compensation error value obtained the last but one time by means of calculation includes:

performing subtraction on the compensation error value obtained last time by means of calculation and the compensation error value obtained the last but one time by means of calculation, where a difference obtained is the first compensation error. Specifically, the processor 32 is further configured to: when receiving the balance compensation result sent by the balance filtering module, calculate a compensation error value of the currently received balance compensation result; and

obtain a second compensation error by means of calculation according to the compensation error value obtained last time by means of calculation and the compensation error value of the currently received balance compensation result, where the second compensation error is used to adjust a currently used balance filtering coefficient.

Specifically, the processor 32 obtains, in the following manner, the $j^{th}$ balance filtering coefficient that is currently used:

$$b_{j(\text{current})} = b_{j(\text{last time})} + \mu * \text{sign}\left(e_{\text{last but one time}} - e_{\text{last time}}\right),$$

where

$b_{j(\text{current})}$ is an obtained coefficient weight of the $j^{\text{th}}$ balance filtering coefficient that is currently used, a value range of $j$ is 0 to $L_b$, $L_b$ is a length of the balance filtering coefficient, $b_{j(\text{last time})}$ is a basic coefficient weight of the $j^{\text{th}}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

Specifically, the processor 32 is further configured to: determine, at an initialization stage, a basic coefficient weight of an initialized balance filtering coefficient according to a coefficient weight of the first filtering coefficient; and obtain an initial value of the balance filtering coefficient according to the basic coefficient weight of the initialized balance filtering coefficient.

Specifically, that the processor 32 determines a basic coefficient weight of an initialized balance filtering coefficient according to a coefficient weight of the first filtering coefficient includes:

if the first filtering coefficient is $F(z) = \sum_{i=0}^{L_f} f_i z^{-i}$ , determining the basic coefficient weight of the initialized balance filtering coefficient in the following manner:

$$b_0 = f_0; b_j = -f_i,$$

where

$b_j$ is a basic coefficient weight of the $j^{\text{th}}$ balance filtering coefficient that is initialized, the value range of $j$ is 0 to $L_b$, $L_b$ is the length of the balance filtering coefficient, $f_i$ is a coefficient weight of the $j^{\text{th}}$ first filtering coefficient, a value range of $i$ is 0 to $L_f$, and $L_f$ is a length of the first filtering coefficient.

Specifically, the processor 32 is further configured to calculate an error result according to a first compensation signal sequence obtained last time and a decision value of the first compensation signal sequence obtained last time, and adjust the first filtering coefficient according to the error result obtained by means of calculation; and use an adjusted first filtering coefficient to perform filtering compensation on the currently received signal sequence, to obtain the first compensation signal sequence.

The processor 32 may be a general processor, including a central processing unit (central processing unit, CPU for short), a network processor (Network Processor, NP for short), and the like; or may be a combination of a CPU and a hardware chip. The processor 32 may also be a digital signal processor (DSP), an application specific integrated circuit (ASIC), a field-programmable gate array (FPGA) or any other programmable logic device, a discrete gate or transistor logic device, or a discrete hardware component.

Persons of ordinary skill in the art may understand that all or a part of the steps in each of the foregoing method of the embodiments may be implemented by a program instructing a processor. The foregoing program may be stored in a computer readable storage medium. The storage medium may be a non-transitory (non-transitory) medium, such as a random-access memory, read-only memory, a flash memory, a hard disk, a solid state drive, a magnetic tape (magnetic tape), a floppy disk (floppy disk), an optical disc (optical disc), or any combination thereof.

The present invention is described with reference to the flowcharts and/or block diagrams of the method, the device, and the computer program product according to the embodiments of the present invention. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

The foregoing descriptions are merely examples of specific implementations of the present invention, but are not intended to limit the protection scope of the present invention. Any variation or replacement readily figured out by persons skilled in the art within the technical scope disclosed in the present invention shall fall within the protection scope of the present invention. Therefore, the protection scope of the present invention shall be subject to the protection scope of the claims.

**Claims**

1. A signal compensation device, comprising a first compensation module (11), a balance filtering module (12), and a second compensation module (13), wherein:

   the first compensation module (11) is configured to receive an input signal sequence suffering from intersymbol interference, ISI, interference, use a first filtering coefficient to perform filtering compensation on the received signal sequence, to obtain a first compensation signal sequence, and send the first compensation signal sequence to the balance filtering module;
   the balance filtering module (12) is configured to use a balance filtering coefficient to perform filtering compensation on the first compensation signal sequence that is sent by the first compensation module, to obtain a balance compensation result, and send the balance compensation result to the second compensation module, wherein the balance filtering coefficient is obtained by adjusting, according to a first compensation error sent by the second compensation module, a balance filtering coefficient used last time; and
   the second compensation module (13) is configured to receive the balance compensation result sent by the balance filtering module, perform sequence estimation on the received balance compensation result and output the balance compensation result, obtain the first compensation error by means of calculation according to a compensation error value obtained last time by means of calculation and a compensation error value obtained the last but one time by means of calculation, and send the first compensation error to the balance filtering module; and
   the signal compensation device being **characterized in that**:

   the balance filtering module (12) is specifically configured to obtain a $j^{\text{th}}$ balance filtering coefficient in the following manner:

   $$b_{j(\text{current})} = b_{j(\text{last time})} + \mu * \text{sign}\left(e_{\text{last but one time}} - e_{\text{last time}}\right),$$

   wherein
   $b_{j(\text{current})}$ is an obtained coefficient weight of the $j^{\text{th}}$ balance filtering coefficient that is currently used, a value range of $j$ is 0 to $L_b$, $L_b$ is a length of the balance filtering coefficient, $b_{j(\text{last time})}$ is a basic coefficient weight of the $j^{\text{th}}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

2. The signal compensation device according to claim 1, wherein:

   the second compensation module (13) is specifically configured to perform subtraction on the compensation error value obtained last time by means of calculation and the compensation error value obtained the last but one time by means of calculation, wherein a difference obtained is the first compensation error.

3. The signal compensation device according to claim 1 or 2, wherein:

   the second compensation module (13) is further configured to: when receiving the balance compensation result sent by the balance filtering module, calculate a compensation error value of the currently received balance compensation result; and
   obtain a second compensation error by means of calculation according to the compensation error value obtained last time by means of calculation and the compensation error value of the currently received balance compensation result, and send the second compensation error obtained by means of calculation to the balance filtering module.

4. The signal compensation device according to any one of claims 1 to 3, wherein:

   the first compensation module (11) is further configured to send, at an initialization stage, the first filtering coefficient to the balance filtering module; and
   the balance filtering module (12) is further configured to receive the first filtering coefficient sent by the first compensation module, determine, according to a coefficient weight of the first filtering coefficient, a basic coefficient weight of an initialized balance filtering coefficient used by the balance filtering module, and obtain an initial value of the balance filtering coefficient according to the basic coefficient weight of the initialized balance filtering coefficient used by the balance filtering module.

5. A signal compensation method, comprising:

receiving (201) an input signal sequence suffering from intersymbol interference, ISI, interference, and using (202) a first filtering coefficient to perform filtering compensation on the received signal sequence, to obtain a first compensation signal sequence;
using (203) a balance filtering coefficient to perform filtering compensation on the first compensation signal sequence, to obtain a balance compensation result, wherein the balance filtering coefficient is obtained by adjusting, according to a first compensation error, a balance filtering coefficient used last time, and the first compensation error is obtained by means of calculation according to a compensation error value obtained last time by means of calculation and a compensation error value obtained the last but one time by means of calculation; and
performing (204) sequence estimation on the obtained balance compensation result and outputting the balance compensation result; and
the method being **characterized in that**:

a $j^{th}$ balance filtering coefficient that is currently used is obtained in the following manner:

$$b_{j(\text{current})} = b_{j(\text{last time})} + \mu * \text{sign} \left( e_{\text{last but one time}} - e_{\text{last time}} \right),$$

wherein
$b_{j(\text{current})}$ is an obtained coefficient weight of the $j^{th}$ balance filtering coefficient that is currently used, a value range of $j$ is 0 to $L_b$, $L_b$ is a length of the balance filtering coefficient, $b_{j(\text{last time})}$ is a basic coefficient weight of the $j^{th}$ balance filtering coefficient used last time, $\mu$ is a coefficient change length of the balance filtering coefficient, $e_{\text{last but one time}} - e_{\text{last time}}$ is the first compensation error, $e_{\text{last but one time}}$ is the compensation error value obtained the last but one time by means of calculation, and $e_{\text{last time}}$ is the compensation error value obtained last time by means of calculation.

6. The signal compensation method according to claim 5, wherein that the first compensation error is obtained by means of calculation according to a compensation error value obtained last time by means of calculation and a compensation error value obtained the last but one time by means of calculation comprises:

performing subtraction on the compensation error value obtained last time by means of calculation and the compensation error value obtained the last but one time by means of calculation, wherein a difference obtained is the first compensation error.

7. The signal compensation method according to claim 5 or 6, wherein the method further comprises:

when obtaining the balance compensation result, calculating a compensation error value of the currently received balance compensation result; and
obtaining a second compensation error by means of calculation according to the compensation error value obtained last time by means of calculation and the compensation error value of the currently received balance compensation result, wherein the second compensation error is used to adjust a currently used balance filtering coefficient.

8. The signal compensation method according to any one of claims 5 to 7, wherein the method further comprises:

determining, at an initialization stage, a basic coefficient weight of an initialized balance filtering coefficient according to a coefficient weight of the first filtering coefficient; and
obtaining an initial value of the balance filtering coefficient according to the basic coefficient weight of the initialized balance filtering coefficient.

**Patentansprüche**

1. Signalkompensierungsvorrichtung, umfassend ein erstes Kompensierungsmodul (11), ein Ausgleichsfiltermodul (12) und ein zweites Kompensierungsmodul (13), wobei:

das erste Kompensierungsmodul (11) ausgelegt ist, eine Eingangssignalsequenz, die an einer Intersymbolinterferenz, ISI-Interferenz, leidet, zu empfangen, einen ersten Filterkoeffizienten zu verwenden, um eine Filterkompensierung an der empfangenen Signalsequenz vorzunehmen, um eine erste Kompensierungssignalsequenz zu erhalten, und die erste Kompensierungssignalsequenz an das Ausgleichsfiltermodul zu senden;
das Ausgleichsfiltermodul (12) ausgelegt ist, einen Ausgleichsfilterkoeffizienten zu verwenden, um eine Filterkompensierung an der ersten Kompensierungssignalsequenz vorzunehmen, die von dem ersten Kompensierungsmodul gesendet wird, um ein Ausgleichskompensierungsergebnis zu erhalten, und das Ausgleichskompensierungsergebnis an das zweite Kompensierungsmodul zu senden, wobei der Ausgleichsfilterkoeffizient erhalten wird, indem, gemäß einem ersten Kompensierungsfehler, der von dem zweiten Kompensierungsmodul gesendet wird, ein Ausgleichsfilterkoeffizient eingestellt wird, der das letzte Mal verwendet wurde; und
das zweite Kompensierungsmodul (13) ausgelegt ist, das Ausgleichskompensierungsergebnis zu erhalten, das von dem Ausgleichsfiltermodul gesendet wird, eine Sequenzschätzung an dem empfangenen Ausgleichskompensierungsergebnis vorzunehmen, und das Ausgleichskompensierungsergebnis auszugeben, den ersten Kompensierungsfehler durch Berechnung gemäß einem Kompensierungsfehlerwert, der das letzte Mal durch Berechnung erhalten wurde, und einen Kompensierungsfehlerwert, der das vorletzte Mal durch Berechnung erhalten wurde, zu erhalten, und den ersten Kompensierungsfehler an das Ausgleichsfiltermodul zu senden; und
die Signalkompensierungsvorrichtung **dadurch gekennzeichnet ist, dass**:

das Ausgleichsfiltermodul (12) spezifisch ausgelegt ist, einen jten Ausgleichsfilterkoeffizienten auf die folgende Weise zu erhalten:

$$b_{j(current)} = b_{j(last\ time)} + \mu * sign(e_{last\ but\ one\ time} - e_{last\ time}),$$

wobei
$b_{j(current)}$ ein erhaltenes Koeffizientengewicht des jten Ausgleichsfilterkoeffizienten ist, der aktuell verwendet wird, ein Wertbereich von $j$ 0 bis $L_b$ ist, $L_b$ eine Länge des Ausgleichsfilterkoeffizienten ist, $b_{j(last\ time)}$ ein Basiskoeffizientengewicht des $j$ten Ausgleichsfilterkoeffizienten ist, der das letzte Mal verwendet wurde, $\mu$ eine Koeffizientenänderungslänge des Ausgleichsfilterkoeffizienten ist, $e_{last\ but\ one\ time} - e_{last\ time}$ der erste Kompensierungsfehler ist, $e_{last\ but\ one\ time}$ der Kompensierungsfehlerwert ist, der das vorletzte Mal durch Berechnung erhalten wurde, und $e_{last}$ time der Kompensierungsfehlerwert ist, der das letzte Mal durch Berechnung erhalten wurde.

2. Signalkompensierungsvorrichtung nach Anspruch 1, wobei:

das zweite Kompensierungsmodul (13) spezifisch ausgelegt ist, eine Subtraktion an dem Kompensierungsfehlerwert, der das letzte Mal durch Berechnung erhalten wurde, und dem Kompensierungsfehlerwert, der das vorletzte Mal durch Berechnung erhalten wurde, vorzunehmen, wobei eine erhaltene Differenz der erste Kompensierungsfehler ist.

3. Signalkompensierungsvorrichtung nach Anspruch 1 oder 2, wobei:

das zweite Kompensierungsmodul (13) ferner ausgelegt ist: wenn das Ausgleichskompensierungsergebnis empfangen wird, das von dem Ausgleichsfiltermodul gesendet wird, einen Kompensierungsfehlerwert des aktuell empfangenen Ausgleichskompensierungsergebnisses zu berechnen; und
einen zweiten Kompensierungsfehler durch Berechnung gemäß dem Kompensierungsfehlerwert, der das letzte Mal durch Berechnung erhalten wurde, und dem Kompensierungsfehlerwert des aktuell empfangenen Ausgleichskompensierungsergebnisses zu erhalten, und den zweiten Kompensierungsfehler, der durch Berechnung erhalten wurde, an das Ausgleichsfiltermodul zu senden.

4. Signalkompensierungsvorrichtung nach einem der Ansprüche 1 bis 3, wobei:

das erste Kompensierungsmodul (11) ferner ausgelegt ist, in einer Initialisierungsstufe, den ersten Filterkoeffizienten an das Ausgleichsfiltermodul zu senden; und

das Ausgleichsfiltermodul (12) ferner ausgelegt ist, den ersten Filterkoeffizienten, der von dem ersten Kompensierungsmodul gesendet wird, zu empfangen, gemäß einem Koeffizientengewicht des ersten Filterkoeffizienten, ein Basiskoeffizientengewicht eines initialisierten Ausgleichsfilterkoeffizienten zu bestimmen, der von dem Ausgleichsfiltermodul verwendet wird, und einen Initialwert des Ausgleichsfilterkoeffizienten gemäß dem Basiskoeffizientengewicht des initialisierten Ausgleichsfilterkoeffizienten zu erhalten, der von dem Ausgleichsfiltermodul verwendet wird.

5. Signalkompensierungsverfahren, umfassend:

Empfangen (201) einer Eingangssignalsequenz, die an einer Intersymbolinterferenz, ISI-Interferenz, leidet, und Verwenden (202) eines ersten Filterkoeffizienten, um eine Filterkompensierung an der empfangenen Signalsequenz vorzunehmen, um eine erste Kompensierungssignalsequenz zu erhalten;

Verwenden (203) eines Ausgleichsfilterkoeffizienten, um eine Filterkompensierung an der ersten Kompensierungssignalsequenz vorzunehmen, um ein Ausgleichskompensierungsergebnis zu erhalten, wobei der Ausgleichsfilterkoeffizient erhalten wird, indem, gemäß einem ersten Kompensierungsfehler, ein Ausgleichsfilterkoeffizient eingestellt wird, der das letzte Mal verwendet wurde, und der erste Kompensierungsfehler durch Berechnung gemäß einem Kompensierungsfehlerwert, der das letzte Mal durch Berechnung erhalten wurde, und einem Kompensierungsfehlerwert, der das vorletzte Mal durch Berechnung erhalten wurde, erhalten wird; und

Vornehmen (204) einer Sequenzschätzung an dem erhaltenen Ausgleichskompensierungsergebnis und Ausgeben des Ausgleichskompensierungsergebnisses; und

wobei das Verfahren **dadurch gekennzeichnet ist, dass**:

ein $j$ter Ausgleichsfilterkoeffizient, der aktuell verwendet wird, auf die folgende Weise erhalten wird:

$$b_{j(current)} = b_{j(last\ time)} + \mu * sign(e_{last\ but\ one\ time} - e_{last\ time}),$$

wobei

$b_{j(current)}$ ein erhaltenes Koeffizientengewicht des $j$ten Ausgleichsfilterkoeffizienten ist, der aktuell verwendet wird, ein Wertbereich von $j$ 0 bis $L_b$ ist, $L_b$ eine Länge des Ausgleichsfilterkoeffizienten ist, $b_{j(last\ time)}$ ein Basiskoeffizientengewicht des $j$ten Ausgleichsfilterkoeffizienten ist, der das letzte Mal verwendet wurde, $\mu$ eine Koeffizientenänderungslänge des Ausgleichsfilterkoeffizienten ist, $e_{last\ but\ one\ time} - e_{last\ time}$ der erste Kompensierungsfehler ist, $e_{last\ but\ one\ time}$ der Kompensierungsfehlerwert ist, der das vorletzte Mal durch Berechnung erhalten wurde, und $e_{last\ time}$ der Kompensierungsfehlerwert ist, der das letzte Mal durch Berechnung erhalten wurde.

6. Signalkompensierungsverfahren nach Anspruch 5, wobei, dass der erste Kompensierungsfehler durch Berechnung gemäß einem Kompensierungsfehlerwert, der das letzte Mal durch Berechnung erhalten wurde, und einem Kompensierungsfehlerwert, der das vorletzte Mal durch Berechnung erhalten wurde, erhalten wird, umfasst:

Vornehmen einer Subtraktion an dem Kompensierungsfehlerwert, der das letzte Mal durch Berechnung erhalten wurde, und dem Kompensierungsfehlerwert, der das vorletzte Mal durch Berechnung erhalten wurde, wobei eine erhaltene Differenz der erste Kompensierungsfehler ist.

7. Signalkompensierungsverfahren nach Anspruch 5 oder 6, wobei das Verfahren ferner umfasst:

wenn das Ausgleichskompensierungsergebnis erhalten wird, Berechnen eines Kompensierungsfehlerwerts des aktuell empfangenen Ausgleichskompensierungsergebnisses; und

Erhalten eines zweiten Kompensierungsfehlers durch Berechnung gemäß dem Kompensierungsfehlerwert, der das letzte Mal durch Berechnung erhalten wurde, und dem Kompensierungsfehlerwert des aktuell empfangenen Ausgleichskompensierungsergebnisses, wobei der zweite Kompensierungsfehler verwendet wird, um einen aktuell verwendeten Ausgleichsfilterkoeffizienten einzustellen.

8. Signalkompensierungsverfahren nach einem der Ansprüche 5 bis 7, wobei das Verfahren ferner umfasst:

Bestimmen, in einer Initialisierungsstufe, eines Basiskoeffizientengewichts eines initialisierten Ausgleichsfilterkoeffizienten gemäß einem Koeffizientengewicht des ersten Filterkoeffizienten; und

Erhalten eines Initialwerts des Ausgleichsfilterkoeffizienten gemäß dem Basiskoeffizientengewicht des initialisierten Ausgleichsfilterkoeffizienten.

## Revendications

1. Dispositif de compensation de signaux, comprenant un premier module de compensation (11), un module de filtrage d'équilibrage (12) et un deuxième module de compensation (13),

le premier module de compensation (11) étant configuré pour recevoir une séquence de signaux d'entrée souffrant d'une interférence du type interférence intersymbole, notée ISI, utiliser un premier coefficient de filtrage pour appliquer une compensation de filtrage sur la séquence de signaux reçue, afin d'obtenir une première séquence de signaux de compensation et envoyer la première séquence de signaux de compensation au module de filtrage d'équilibrage ;

le module de filtrage d'équilibrage (12) étant configuré pour utiliser un coefficient de filtrage d'équilibrage pour appliquer une compensation de filtrage sur la première séquence de signaux de compensation envoyée par le premier module de compensation, afin d'obtenir un résultat de compensation d'équilibrage, et envoyer le résultat de compensation d'équilibrage au deuxième module de compensation, le coefficient de filtrage d'équilibrage étant obtenu par ajustement, selon une première erreur de compensation envoyée par le deuxième module de compensation, d'un coefficient de filtrage d'équilibrage utilisé la dernière fois ; et

le deuxième module de compensation (13) étant configuré pour recevoir le résultat de compensation d'équilibrage envoyé par le module de filtrage d'équilibrage, appliquer une estimation de séquence sur le résultat de compensation d'équilibrage reçu et fournir en sortie le résultat de compensation d'équilibrage, obtenir la première erreur de compensation par calcul selon une valeur d'erreur de compensation obtenue la dernière fois par calcul et une valeur d'erreur de compensation obtenue l'avant-dernière fois par calcul, et envoyer la première erreur de compensation au module de filtrage d'équilibrage ; et

le dispositif de compensation de signaux étant **caractérisé en ce que** :

le module de filtrage d'équilibrage (12) est plus particulièrement configuré pour obtenir un $j$-ème coefficient de filtrage d'équilibrage de la manière suivante :

$$b_{j(\text{current})} = b_{j(\text{last time})} + \mu^* \text{sign} \left( e_{\text{last but one time}} - e_{\text{last time}} \right),$$

$b_{j(\text{current})}$ étant un poids de coefficient obtenu du $j$-ème coefficient de filtrage d'équilibrage actuellement utilisé, un intervalle de valeurs de $j$ allant de 0 à $L_b$, $L_b$ étant une longueur du coefficient de filtrage d'équilibrage, $b_{j(\text{last time})}$ étant un poids de coefficient de base du $j$-ème coefficient de filtrage d'équilibrage utilisé la dernière fois, $\mu$ étant une longueur de variation de coefficient du coefficient de filtrage d'équilibrage, $e_{\text{last but one time}} - e_{\text{last time}}$ étant la première erreur de compensation, $e_{\text{last but one time}}$ étant la valeur d'erreur de compensation obtenue l'avant-dernière fois par calcul et $e_{\text{last time}}$ étant la valeur d'erreur de compensation obtenue la dernière fois par calcul.

2. Dispositif de compensation de signaux selon la revendication 1, dans lequel :

le deuxième module de compensation (13) est plus particulièrement configuré pour appliquer une soustraction sur la valeur d'erreur de compensation obtenue la dernière fois par calcul et la valeur d'erreur de compensation obtenue l'avant-dernière fois par calcul, une différence obtenue étant la première erreur de compensation.

3. Dispositif de compensation de signaux selon la revendication 1 ou 2, dans lequel :

le deuxième module de compensation (13) est configuré en outre pour : lorsqu'il reçoit le résultat de compensation d'équilibrage envoyé par le module de filtrage d'équilibrage, calculer une valeur d'erreur de compensation du résultat de compensation d'équilibrage actuellement reçu ; et

obtenir une deuxième erreur de compensation par calcul selon la valeur d'erreur de compensation obtenue la dernière fois par calcul et la valeur d'erreur de compensation du résultat de compensation d'équilibrage actuellement reçu, et envoyer la deuxième erreur de compensation obtenue par calcul au module de filtrage d'équilibrage.

4. Dispositif de compensation de signaux selon l'une quelconque des revendications 1 à 3, dans lequel :

le premier module de compensation (11) est configuré en outre pour envoyer, à un stade d'initialisation, le premier coefficient de filtrage au module de filtrage d'équilibrage ; et
le module de filtrage d'équilibrage (12) est configuré en outre pour recevoir le premier coefficient de filtrage envoyé par le premier module de compensation, déterminer, selon un poids de coefficient du premier coefficient de filtrage, un poids de coefficient de base d'un coefficient de filtrage d'équilibrage initialisé utilisé par le module de filtrage d'équilibrage et obtenir une valeur initiale du coefficient de filtrage d'équilibrage selon le poids de coefficient de base du coefficient de filtrage d'équilibrage initialisé utilisé par le module de filtrage d'équilibrage.

5. Procédé de compensation de signaux, comprenant :

la réception (201) d'une séquence de signaux d'entrée souffrant d'une interférence du type interférence intersymbole, notée ISI, et l'utilisation (202) d'un premier coefficient de filtrage pour appliquer une compensation de filtrage sur la séquence de signaux reçue afin d'obtenir une première séquence de signaux de compensation ;
l'utilisation (203) d'un coefficient de filtrage d'équilibrage pour appliquer une compensation de filtrage sur la première séquence de signaux de compensation afin d'obtenir un résultat de compensation d'équilibrage, le coefficient de filtrage d'équilibrage étant obtenu par ajustement, selon une première erreur de compensation, d'un coefficient de filtrage d'équilibrage utilisé la dernière fois, et la première erreur de compensation étant obtenue par calcul selon une valeur d'erreur de compensation obtenue la dernière fois par calcul et une valeur d'erreur de compensation obtenue l'avant-dernière fois par calcul ; et
l'application (204) d'une estimation de séquence sur le résultat de compensation d'équilibrage obtenu et la fourniture en sortie du résultat de compensation d'équilibrage ; et
le procédé étant **caractérisé en ce que** :

un $j$-ème coefficient de filtrage d'équilibrage actuellement utilisé est obtenu de la manière suivante :

$$b_{j(\text{current})} = b_{j(\text{last time})} + \mu * \text{sign}\,(e_{\text{last but one time}} - e_{\text{last time}}),$$

$b_{j(\text{current})}$ étant un poids de coefficient obtenu du $j$-ème coefficient de filtrage d'équilibrage actuellement utilisé, un intervalle de valeurs de $j$ allant de 0 à $L_b$, $L_b$ étant une longueur du coefficient de filtrage d'équilibrage, $b_{j(\text{last time})}$ étant un poids de coefficient de base du $j$-ème coefficient de filtrage d'équilibrage utilisé la dernière fois, $\mu$ étant une longueur de variation de coefficient du coefficient de filtrage d'équilibrage, $e_{\text{last but one time}}$ - $e_{\text{last time}}$ étant la première erreur de compensation, $e_{\text{last but one time}}$ étant la valeur d'erreur de compensation obtenue l'avant-dernière fois par calcul et $e_{\text{last time}}$ étant la valeur d'erreur de compensation obtenue la dernière fois par calcul.

6. Procédé de compensation de signaux selon la revendication 5, dans lequel le fait que la première erreur de compensation est obtenue par calcul selon une valeur d'erreur de compensation obtenue la dernière fois par calcul et une valeur d'erreur de compensation obtenue l'avant-dernière fois par calcul comprend :

l'application d'une soustraction sur la valeur d'erreur de compensation obtenue la dernière fois par calcul et la valeur d'erreur de compensation obtenue l'avant-dernière fois par calcul, une différence obtenue étant la première erreur de compensation.

7. Procédé de compensation de signaux selon la revendication 5 ou 6, lequel procédé comprend en outre :

lors de l'obtention du résultat de compensation d'équilibrage, le calcul d'une valeur d'erreur de compensation du résultat de compensation d'équilibrage actuellement reçu ; et
l'obtention d'une deuxième erreur de compensation par calcul selon la valeur d'erreur de compensation obtenue la dernière fois par calcul et la valeur d'erreur de compensation du résultat de compensation d'équilibrage actuellement reçu, la deuxième erreur de compensation servant à ajuster un coefficient de filtrage d'équilibrage actuellement utilisé.

8. Procédé de compensation de signaux selon l'une quelconque des revendications 5 à 7, lequel procédé comprend en outre :

la détermination, à un stade d'initialisation, d'un poids de coefficient de base d'un coefficient de filtrage d'équilibrage initialisé selon un poids de coefficient du premier coefficient de filtrage ; et
l'obtention d'une valeur initiale du coefficient de filtrage d'équilibrage selon le poids de coefficient de base du coefficient de filtrage d'équilibrage initialisé.

FIG. 1

201

Receive an input signal sequence suffering from ISI interference

202

Use a first filtering coefficient to perform filtering compensation on the received signal sequence, to obtain a first compensation signal sequence

203

Use a balance filtering coefficient to perform filtering compensation on the first compensation signal sequence, to obtain a balance compensation result

204

Perform sequence estimation on the received balance compensation result and output the balance compensation result

205

When receiving the balance compensation result sent by the balance filtering module, calculate a compensation error of the currently received balance compensation result; and use a compensation error value obtained last time by means of calculation and the compensation error value of the currently received balance compensation result

FIG. 2

EP 3 217 618 B1

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5031195 A
- US 2006245765 A1